Europäisches Patentamt

European Patent Office

Office européen des brevets

(19)

(11) Publication number: **0 408 054 A2**

# EUROPEAN PATENT APPLICATION

(21) Application number: 90113445.2

(22) Date of filing: **13.07.90**

(51) Int. Cl.⁵: **H01L 29/788, H01L 21/318**

(30) Priority: 14.07.89 JP 181758/89
05.07.90 JP 178084/90

(43) Date of publication of application:
**16.01.91 Bulletin 91/03**

(84) Designated Contracting States:
**DE FR GB**

(71) Applicant: **Kabushiki Kaisha Toshiba**
**72, Horikawa-cho Saiwai-ku**
**Kawasaki-shi(JP)**

(72) Inventor: **Miyamoto, Koji, c/o Intellectual**
**Property Div.**
**Kabushiki Kaisha Toshiba, 1-1 Shibaura**
**1-chome**
Minato-ku, Tokyo 105(JP)
Inventor: **Warita, Yoshihiko, c/o Intellectual**
**Property Div.**
**Kabushiki Kaisha Toshiba, 1-1 Shibaura**
**1-chome**
Minato-ku, Tokyo 105(JP)
Inventor: **Hanada, Naoki, c/o Intellectual**
**Property Div.**
**Kabushiki Kaisha Toshiba, 1-1 Shibaura**
**1-chome**
Minato-ku, Tokyo 105(JP)

(74) Representative: **Lehn, Werner, Dipl.-Ing. et al**
**Hoffmann, Eitle & Partner Patentanwälte**
**Arabellastrasse 4e 4**
**D-8000 München 81(DE)**

(54) Ultraviolet erasable non-volatile semiconductor memory apparatus.

(57) A silicon nitride film (36) is used as a passivation film for an ultraviolet erasable non-volatile semiconductor memory appartus, such as an EPROM. The nitride film has a large stress that is to act on an underlying layer, so that if the underlying layer is a metal inter connection layer (32A, 32B) made of aluminum or the like, it is likely to be destroyed quenched. Therefore, an insulating film, such as a PSG film or silicon oxide film, is formed between the nitride film (36) and metal inter connection layer (32A, 32B) to reduce the stress of the former film (36) acting on the latter (32A, 32B). The nitride film (36) is formed by a plasma method can reduce the growth temperature to approximately 350 to 400°C, which prevents destruction of the metal line layer pattern.

FIG. 1

## ULTRAVIOLET ERASABLE NON-VOLATILE SEMICONDUCTOR MEMORY APPARATUS

The present invention relates to an ultraviolet erasable non-volatile semiconductor memory apparatus, and, more particularly, to the improvement of a passivation film of this semiconductor memory apparatus.

EPROMs are known as an ultraviolet erasable non-volatile semiconductor memory apparatus. An EPROM has a floating gate in a memory cell. The EPROM accumulates charges in the floating gate to change the threshold value of a cell-transistor and stores information in the form of "0" and "1" which are realized by the non-conductive and conductive states of the transistor.

To erase the stored information, ultraviolet-light are irradiated to the target memory-cell to excite the charges accumulated in the floating gate so that the charges are discharged into, for example, a substrate, going over the barrier of a gate insulating film.

That is, EPROMs erase information by irradiation of ultraviolet rays. In this respect, EPROMs need to employ, as a passivation film, an insulating film wit high transmittivity of ultraviolet rays (wavelength of 253.7 nm). For example, a PSG film and an SiO film serve as such an insulating film having high ultraviolet transmittivity. These two films, however, have a poor effect to shield an external contaminated mobile ion. Those films specifically pass sodium ion that causes alteration in the threshold value of a cell-transistor or a peripheral transistor.

Great attention has been paid to an SiN film as a passivation film which has a high shielding effect to an external contaminated mobil ion. The ratio of silicon to nitrogen for this SiN film is normally set to 0.93 for stress suppressing. The SiN film with the ratio Si/N set to this value is generally treated as having a poor ultraviolet transmittivity. Published Unexamined Japanese Patent Application No. 57-177555 discloses that setting the silicon-to-nitrogen ratio Si/N in a range of 0.65 to 0.825 improves the transmittivity of ultraviolet light having a particular wavelength of approximately 300 nm or less. As the wavelength effective in erasing information stored in an EPROM is approximately 253.7 nm, an SiN film having the ratio Si/N set in a range of 0.65 to 0.825 well passes ultraviolet light with a wavelength of about 253.7 nm.

The SiN film with the ratio Si/N set in this range, however, has a large stress that influences an underlying-layer.

Our researches show that SiN films with the ratio Si/N set to approximately 0.75 has an underlying-layer influencing stress of about $8 \times 10^9$ dyne/cm$^2$, which is nearly four times greater than that of an SiN film whose ratio Si/N is set to approximately 0.93.

Under the circumstances, an overstress is applied to an aluminum inter connection layer, thus degrading the reliability of the layer. For instance, such overstress, when applied to an aluminum inter connection layer, may destroy the layer. The tendency or efforts to provide ever finer or micro-fabricated apparatuses with the small inter connection layer size. This would likely increase the stress applied to the layer. Therefore, destroy of the layer caused by the stress would be a big issue.

Accordingly, it is an object of the present invention to reduce the stress on the underlying layer in using a SiN film as a passivation film for and ultraviolet erasable non-volatile semiconductor memory apparatus.

To achieve the object, according to the present invention, there is provided an ultraviolet erasable non-volatile semiconductor memory apparatus comprising:

a metal inter connection layer formed above a semiconductor substrate;

a first insulating film formed adjacent to the metal inter connection layer; and

a second insulating film containing nitrogen, formed on the first insulating film.

According to the thus fabricated semiconductor apparatus, the first insulating film is formed between the second insulating film containing nitrogen and the metal inter connection layer. This structure can reduce the stress of the second insulating film acting on the metal inter connection layer, thus improving the reliability of the metal inter connection layer, for example, the reliability concerning the destroying metal lines.

This invention can be more fully understood from the following detailed description when taken in conjunction with the accompanying drawings, in which:

Fig. 1 is a cross section of the first embodiment of an EPROM according to the present invention, with a particular attention given to a memory cell portion.

Figs. 2A through 2E are cross sections illustrating a sequence of steps of fabricating the first embodiment of an EPROM according to the present invention;

Fig. 3 is a cross section of the second embodiment of an EPROM according to the present invention, with a particular attention given to a memory cell portion;

Fig. 4 is a cross section of the third embodiment of an EPROM according to the present invention, with a particular attention given to a memory cell portion;

Fig. 5 is a diagram showing the percentage of defective units of conventional products and the percentage of defective units of the present products;

Fig. 6 shows stored-information erasing characteristics of an EPROM having a ratio of Si to N (Si/N) in an SiN film set to approximately 0.75 and an EPROM having a ratio Si/N set to approximately 0.93;

Fig. 7 illustrates the results of an experiment of leaving the first embodiment of an EPROM product (peripheral-transistor) in an environment of a high temperature and a high humidity for a certain period of time, then checking its function;

Fig. 8 is a diagram showing the relation between the wavelength of ultraviolet light and the transmittivity of a P-SiN film whose ratio Si/N is set to about 0.75; and

Fig. 9 is a diagram showing the relation between the wavelength of light and the transmittivity of a P-SiN film whose ratio Si/N is set to about 0.93.

Preferred embodiments of an ultraviolet erasable non-volatile semiconductor memory apparatus according to the present invention will be described below referring to the accompanying drawings.

First Embodiment

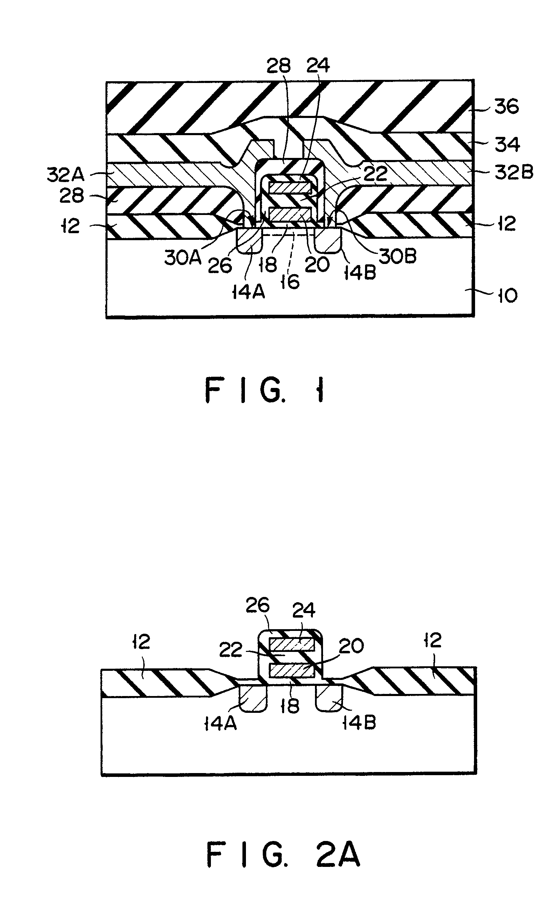

Fig. 1 presents a cross section of the first embodiment of an EPROM according to the present invention, with a particular attention given to a memory cell portion.

As illustrated in this diagram, a field insulating film 12 is formed on the surface region of a semiconductor substrate 10 of a P type, for example (e.g., silicon substrate) to isolate devices. In a device region separated by the field insulating film 12 are formed $n^+$ diffusion layers 14A and 14B with a high impurity concentration as the source/drain regions. A first gate insulating film 18 is formed on the substrate region between the $n^+$ diffusion layers 14A and 14B or on a channel region 16. A floating gate 20 is formed on the first gate insulating film 18. On the floating gate 20 lies a second gate insulating film 22 on which a control gate 24 is formed. The floating gate 20 and control gate 24 are made of silicon, for example. Around the gates, an $SiO_2$ film 26 is formed by, for example, a heat treatment in the fabrication process. A first PSG (Phosphorus-Silicate Glass) film 28 is formed as an interlayer insulating film on these gates, covering them. This PSG film 28 has a thickness of several thousand angstroms, for example. In the PSG film 28 are formed contact holes 30A and 30B which communicate with the $n^+$ diffusion layers 14A and 14B. Formed on the PSG film 28 is a metal film (of aluminum, for example) which is patterned to provide metal inter connection layers 32A and 32B. A second PSG film 34 is formed as a first passivation film on these metal inter connection layers 32A and 32B; this film 34 likewise has a thickness of several thousand angstroms. On the second PSG film 34, a plasma SiN film (hereinafter referred to as P-SiN film) 36 is deposited as a second passivation film using a plasma CVD method, for example. The P-SiN film 36 has a thickness of, for example, several thousand angstroms. In order to improve the transmittivity of ultraviolet light, particularly, those having a wavelength of approximately 300 nm, the ratio of Si and N in the P-SiN film 36 is set to 0.825 or smaller. According to the first embodiment of an EPROM, the ratio Si/N is set to about 0.75 as one example.

In the thus fabricated first embodiment of an EPROM, the second PSG film 34 and P-SiN film 36 are formed as passivation films on the metal inter connection layers 32A and 32B. Forming the PSG film 34 between the P-SiN film 36 and the metal line layers 32A and 32B can reduce the stress of the P-SiN film 36 acting on the metal line layers 32A and 32B.

Accordingly, the EPROM embodying the present invention has higher reliability concerning the destroying of metal inter connection layers and can improve the production yield. After the EPROM is completed, the metal inter connection layers have a longer life due to less stress applied thereto, thus elongating the life of the EPROM.

It should be noted that the metal inter connection layers 32A and 32B are those of e.g., final metal inter connection layers which are closest to the surface layer of the apparatus.

Using the P-SiN film 36 as a passivation film provides higher effect of shielding a contaminated mobil ion coming from outside the apparatus. It is possible to effectively shield sodium, in particular, that alters the threshold value of a cell transistor- or peripheral-transistor, resulting in less change in the characteristic of an EPROM. Further, using the P-SiN film 36 can provide an excellent wet-proof.

The PSG film 34 is capable of gettering a contaminated mobil ion as well as reducing the stress on the metal inter connection layers 32A and 32B. This ability can protect the EPROM from the mobil ion existing in the apparatus.

Accordingly, the first embodiment of an EPROM can protect devices from contaminated mobil ion from both outside and inside the apparatus, thus providing highly-reliable devices and forming the same with high yield.

Although the first PSG film 28 is used as an interlayer insulating film in this embodiment, another film such as a BPSG (Boron-Phosphorus-Silicate Glass) film may be used as well.

Referring to Figs. 2A to 2E, an example of a method of fabricating an EPROM embodying the present invention will be described below. Figs. 2A through 2E are cross sections illustrating a sequence of steps of fabricating the first embodiment of an EPROM according to the present invention. The same reference numerals as used in Fig. 1 are likewise used in Figs. 2A-2E.

As shown in Fig. 2A, first, the field insulating film 12 is formed on the surface region of the p type silicon substrate 10 using, for example, a LOCOS method to isolate devices. Then, the first gate insulating film 18 is formed on silicon exposed to the isolated device regions using a thermal oxidization method, for example. Subsequently, the first polysilicon layer to be the floating gate or the like of the EPROM is deposited on the entire surface of the apparatus using, for example, a CVD method. Cell-slits (not shown), which are gaps to separate the floating gate for the individual memory cells, are formed in the first polysilicon layer. The second insulating film 22 is then formed on the first polysilicon layer using, for example, a thermal oxidization method. Then, the second polysilicon layer serving as the control gate or the like of the EPROM is deposited on the entire surface of the apparatus by the CVD method, for example. The second polysilicon layer is then etched to form a control gate pattern using, for example, a photoetching technique, such as the RIE method, and the etching is carried out to the first polysilicon layer to form the control gate 24, the second insulating film 22 and the floating gate 20. The first gate insulating film 18 formed in a device region, excluding the bottom of the floating gate 20, is etched to expose silicon to the device region. With the field insulating film 12 and control gate 24 as masks, an n type impurity (phosphorus or arsenic) is ion-implanted into the substrate 10. The resultant structure is then subjected to a heat treatment to activate the implanted ions to some degree, forming the source/drain regions 14A and 14B. Fig. 2A illustrates the oxidized film 26 which has been formed through various heat treatments on that surface where the control gate 24 and floating gate 20 are exposed.

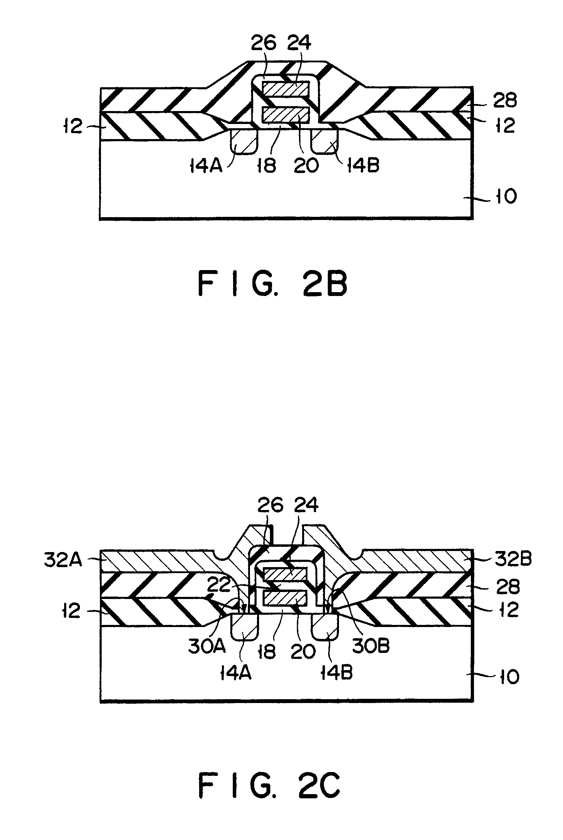

As shown in Fig. 2B, the PSG film 28, for example, is deposited as an interlayer insulating film on the entire surface of the apparatus by, for example, the CVD method. The resultant structure is then heat-treated to carry out reflowing of the PSG film 28.

Then, as shown in Fig. 2C, the contact holes 30A and 30B communicating with predetermined portions of the apparatus (source/drain regions 14A and 14B in the diagram) are formed in the PSG film 28. Subsequently, an aluminum film, for example, is deposited on the entire surface of the apparatus by a sputtering method, for example. The aluminum film is then etched to provide the metal inter connection layer pattern by the photoetching technique to form the metal line layers 32A and 32B.

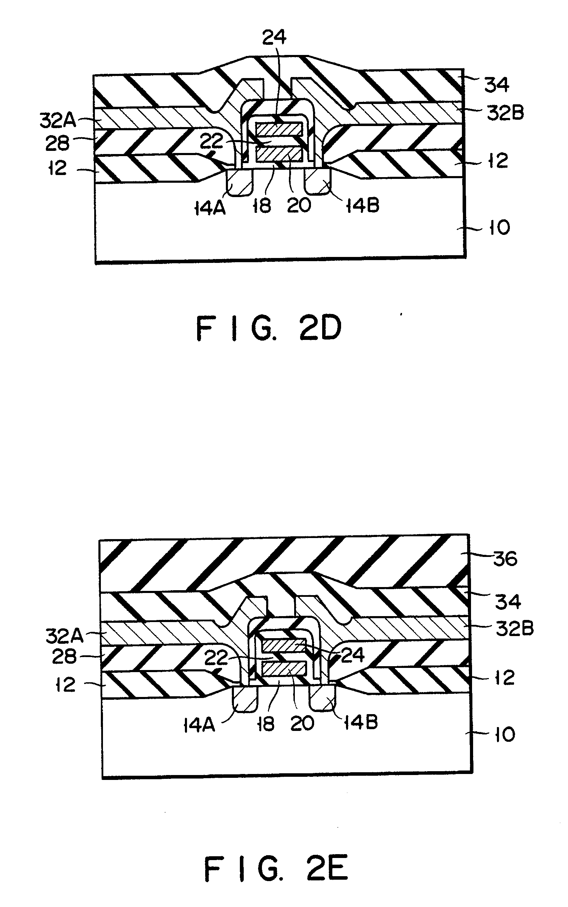

Then, as the first passivation film, the second PSG film 34 is deposited to a thickness of several thousand angstroms by, for example, the CVD method, as shown in Fig. 2D.

Then, as the second passivation film, the P-SiN film 36 is deposited to a thickness of several thousand angstroms by, for example, the plasma CVD method, as shown in Fig. 2E. It should be noted that the ratio Si/N of the P-SiN film 36 is set to 0.825 or smaller. The range of the ratio Si/N can be realized by controlling the flow rate of $SiH_4$, the flow rate of $NH_3$, the degree of vacuum at the time of film deposition, and the power and temperature of the plasma-RF.

The use of the plasma CVD method can form the P-SiN film 36 at lower temperature as compared with the SiN film being formed by the ordinary CVD method. More specifically, the growth temperature of the SiN film by the ordinary CVD method is approximately 700°C, whereas the growth temperature of the P-SiN film 36 formed by the plasma-CVD method is approximately 350 to 400°C. If the SiN film is formed at 700°C, for instance, aluminum would likely be melted, thus destructing the metal inter connection layer pattern. In contrast, forming the SiN film using the plasma-CVD method as in this embodiment can prevent the metal inter connection layer from being destructed by a high temperature.

Further, as the fabrication process can be carried out at a low temperature, this embodiment is effective in making shallower the diffusion regions, such as the source/drain regions, of a cell transistor (n channel type) or a peripheral transistor (CMOS), for example.

Through the above steps, the first embodiment of an EPROM is fabricated.

Second Embodiment

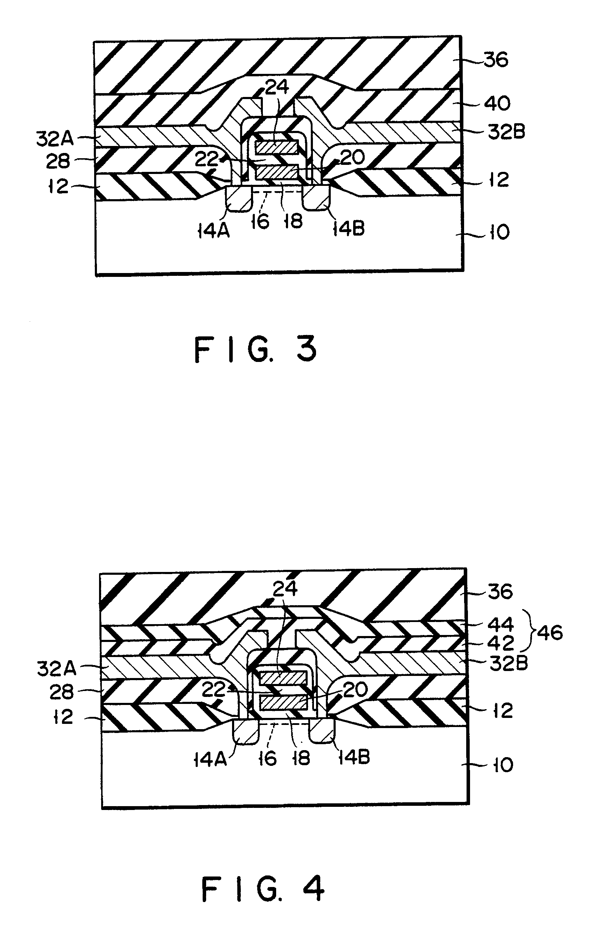

Fig. 3 is a cross section of the second embodiment of an EPROM according to the present invention, with a particular attention given to a memory cell portion. The same reference numerals as used in Fig. 1 are used in Fig. 3 to denote corresponding or identical portions, and only different portions will be described below.

As illustrated in Fig. 3 the second embodiment of an EPROM employs a plasma SiO film (hereinafter referred to as P-SiO film) 40 as the first passivation film, which is deposited by, for example, the plasma-CVD method.

In the thus fabricated second embodiment of an EPROM, forming the P-SiO film 40 between the P-SiN film 36 and the metal line layers 32A and 32B can reduce the stress of the P-SiN film 36 acting on the metal inter connection layers 32A and 32B, as per the first embodiment.

The P-SiO film 40 has a good step-coverage in addition to the effect of reducing the stress on the metal inter connection layers 32A and 32B. It is therefore possible to sufficiently fill the P-SiO film 40 between the e.g., final inter connection layers, such as the metal inter connection layers 32A and 32B.

According to the second embodiment of an EPROM, therefore, it is possible to suppress the occurrence of a void in an insulating film deposited particularly on the metal inter connection layers.

The fabrication steps of the second embodiment are almost the same as those of the first embodiment, except that the P-SiO film 40 in place of the PSG film is deposited by the plasma-CVD method.

Third Embodiment

Fig. 4 is a cross section of the third embodiment of an EPROM according to the present invention, with a particular attention given to a memory cell portion. The same reference numerals as used in Fig. 1 are used in Fig. 4 to denote corresponding or identical portions, and only different portions will be described below.

As illustrated in Fig. 4, the third embodiment of an EPROM employs a laminated film 46 comprising a P-SiO film 42 deposited by, for example, the plasma-CVD method and a PSG film 44 deposited by the CVD method, as the first passivation film.

In the thus fabricated third embodiment of an EPROM, forming the laminated film 46 comprising the P-SiO film 42 and PSG film 44 between the P-SiN film 36 and the metal inter connection layers 32A and 32B can reduce the stress of the P-SiN film 36 acting on the metal inter connection layers 32A and 32B, as per the first and second embodiments.

Employing the laminated film 46 can realize the gettering effect of the PSG film 44 as well as a good step coverage of the P-SiO film 42.

Although the number of layers laminated in the laminated film 46 and the lamination order are not restricted, it is desirable that the P-SiO film be formed adjacent to the metal line layer in light of the good step-coverage of the P-SiO film.

The fabrication steps of the third embodiment are substantially the same as those of the first embodiment, except that, in place of the PSG film in the first embodiment, the P-SiO film 42 is deposited by the plasma-CVD method, then the PSG film 44 is deposited by the CVD method.

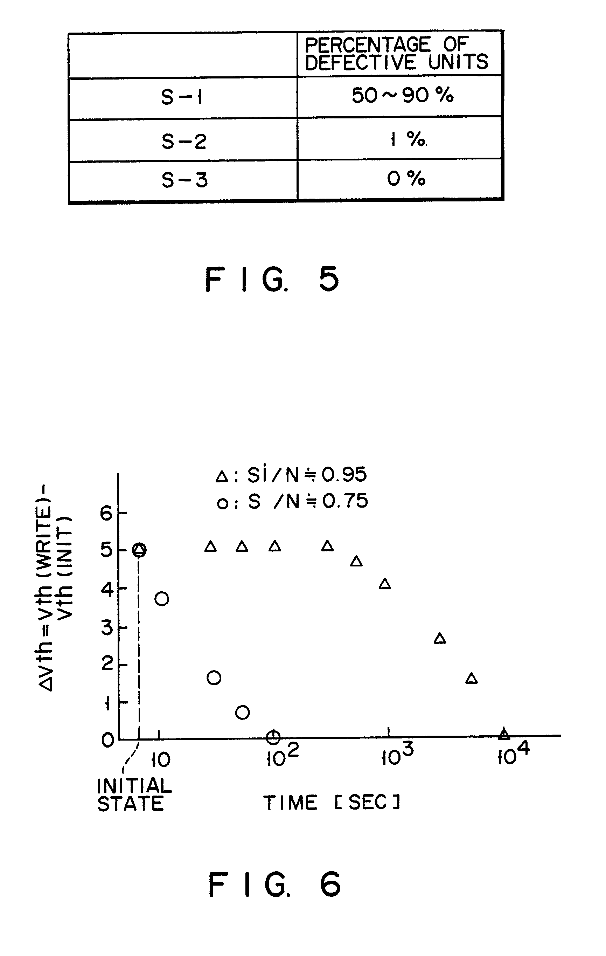

Fig. 5 is a diagram showing the percentage of defective units of conventional products and the percentage of defective units of the present products.

Referring to Fig. 5, S-1 indicates an EPROM having a P-SiN film directly deposited on the final metal inter connection layer, S-2 indicates an EPROM having a P-SiN film deposited on the final metal inter connection layer through a PSG film, and S-3 indicates an EPROM having a P-SiN film deposited on the final metal inter connection layer through a P-SiO film.

The ratio Si/N of the P-SiN film in S-1, S-2 and S-3 is set to approximately 0.75. The test conditions are:
Temperature = 150°C
Left-over time = 2000 hours

As illustrated in Fig. 5, the test shows occurrence of about 50 to 90% of defective units for the EPROM indicated by S-1, while the 0 to 1% of defective units are yielded for the EPROMs indicated by S-2 and S-3.

The test results prove that the EPROMs embodying the present invention have a sufficient withstandability under severe conditions.

Fig. 6 shows stored-information erasing characteristics of an EPROM having a Si-to-N ratio (Si/N) in an SiN film set to approximately 0.75 and an EPROM having a ratio Si/N set to approximately 0.93. The characteristics are obtained for the wavelength of ultraviolet light being 253.7 nm.

In this diagram, the vertical scale is $\Delta$Vth which is the threshold value Vth(init) at the initial state subtracted from the threshold value Vth(write) at the time data is written, and the horizontal scale is the erasing time.

As shown in Fig. 6, the time required for $\Delta$Vth to become zero is approximately $10^2$ seconds for an EPROM whose ratio Si/N is set to about 0.75, and is approximately $10^4$ seconds for an EPROM whose ratio Si/N is set to about 0.93.

From the stored-information erasing characteristics, it is clear that the EPROM using a P-SiN film whose ratio Si/N is set to approximately 0.75 as a passivation film, has an excellent characteristic of erasing stored-information by ultraviolet light.

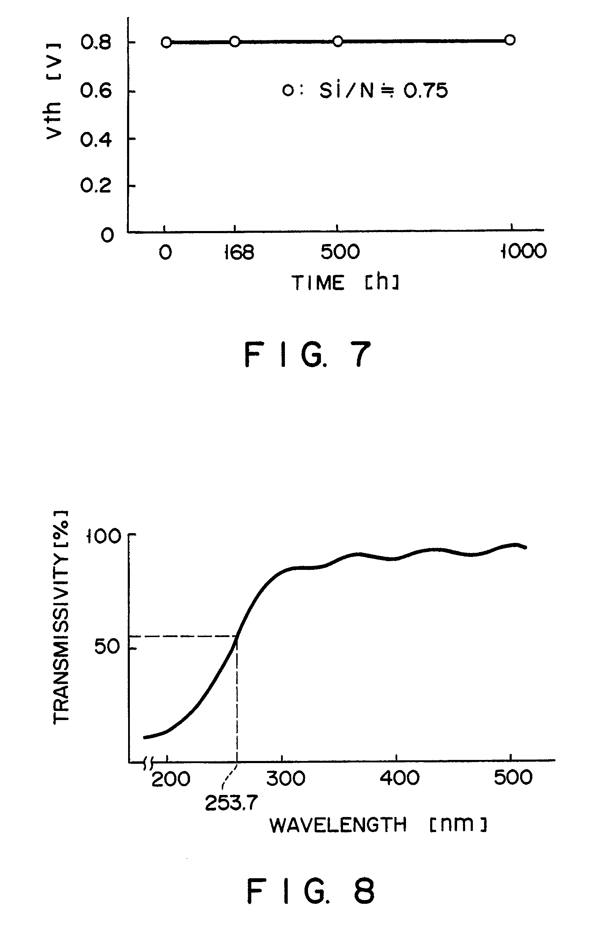

Fig. 7 illustrates the results of an experiment of leaving the first embodiment of an EPROM product in an environment of a high temperature and a high humidity for a certain period of time, then checking its function. The test were conducted at a temperature of 85°C and a humidity of 85% with $V_{cc}$ = -6V. Fig. 7 particularly shows a variation in threshold value of a peripheral-transistor (p channel type) which is an EPROM product.

As illustrated in this diagram, even with the peripheral transistor being left for 1000 hours under the above conditions, the threshold value Vth of this transistor hardly changes. From the test results, it is clear that the first embodiment of an EPROM has a great effect of shielding an external contaminated mobil ion and an excellent wet-proof property.

Fig. 8 is a diagram showing the relation between the wavelength of ultraviolet light and the transmittivity of a P-SiN film whose ratio Si/N is set to about 0.75.

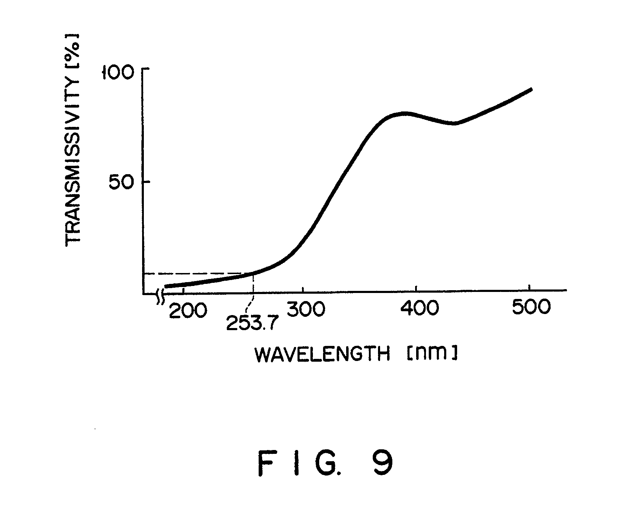

Fig. 9 is a diagram showing the relation between the wavelength of ultraviolet light and the transmittivity of a P-SiN film whose ratio Si/N is set to about 0.93.

As shown in Fig. 8, the transmittivity exceeds 50% when the ratio Si/N is approximately 0.75 with the wavelength of ultraviolet rays suitable for erasing stored information being about 253.7 nm. As shown in Fig. 9, however, the transmittivity is reduced to 10% when the ratio Si/N is approximately 0.93.

It is understood from Figs. 8 and 9 that the P-SiN film whose ratio Si/N is set to approximately 0.75 or set to 0.825 or smaller has an excellent ultraviolet light transmittivity.

Our researches show that the greater the ratio of N in the P-SiN film, the better the transmittivity of the ultraviolet light, particularly, those having a wavelength of 300 nm or less. For instance, a P-SiN film whose ratio Si/N is approximately 0.60 better pass ultraviolet light with a wavelength of 300 nm or less than a P-SiN film whose ratio Si/N is approximately 0.75. In addition to this tendency, there becomes apparent that the higher the ratio of N, the greater the stress of the P-SiN film acting on the underlying layer.

According to the present invention, a PSG film or P-SiO film or the like is formed adjacent to a metal line layer, then a P-SiN film is formed on the former film. With this structure, the stress is difficult to be applied to the metal inter connection layer even if a P-SiN film whose ratio Si/N is set to approximately 0.60, 0.55, 0.50, 0.45, ... etc. is used as a passivation film. It is therefore possible to use a P-SiN film which has as high a nitrogen ratio as possible and well passes ultraviolet light, while overcoming the stress problem.

The present invention is not restricted to the first to third embodiments, but may be modified in various manners without departing from the scope and spirit of the invention. For instance, a PSG film serving as an interlayer insulating film may be replaced by another silicate glass base insulating film, such as a BSG (Boron-Silicate Glass) film or BPSG film.

Dielectrics which constitute the metal inter connection layers 32A and 32B and various gates are not limited to aluminum and polysilicon, but may be tungsten, gold or other dielectric members. For instance, even if tungsten or gold is used for the metal inter connection layers 32A and 32B, the stress acting on these metal inter connection layers can be reduced by forming the PSG film 34, P-SiO film 40 or insulated film 46 between the P-SiN film 36 and the metal line layers. In addition, the shapes, sizes and lengths of the metal line layers 32A and 32B may be arbitrarily set.

Further, the film formed between the P-SiN film 36 and the metal inter connection layers 32A and 32B is not limited to the PSG film 34, P-SiO film 40 or insulated film 46, another type can be used as long as it has an excellent transmittivity for ultraviolet rays, particularly, those having a wavelength of 300 nm or less. For instance the film may be another silicate glass base insulating film, such as a BSG (Boron-Silicate Glass) film or BPSG film.

Although the foregoing description of the preferred embodiments has been given with reference to a memory cell of an EPROM as an example of an active device that needs irradiation of ultraviolet rays, the present invention can apply not only to an EPROM but also an image sensor employing a different device, such as a photodiode, which also requires irradiation of ultraviolet light.

Reference signs in the claims are intended for better understanding and shall not limit the scope.

## Claims

1. An ultraviolet erasable non-volatile semiconductor memory apparatus having a metal inter connection layer (32A, 32B) formed above a semiconductor substrate (10), characterized by further comprising:
a first insulating film (34, 40, 46) formed adjacent to said metal inter connection layer (32A, 32B); and
a second insulating film (36) containing nitrogen, formed on said first insulating film (34, 40, 46).

2. An apparatus according to claim 1, characterized in that said second insulating film (36) is a silicon nitride film whose silicon-to-nitrogen ratio (Si/N) is set to 0.825 or smaller.

3. An apparatus according to claim 2, characterized in that said silicon nitride film (36) is a plasma silicon nitride film formed by a plasma method.

4. An apparatus according to claim 1, characterized in that said first insulating film (34, 40, 46) is a silicate glass base insulating film (34).

5. An apparatus according to claim 4, characterized in that said silicate glass base insulating film (34) is a PSG film.

6. An apparatus according to claim 1, characterized in that said first insulating film (34, 40, 46) is an insulating film (4u) containing oxygen.

7. An apparatus according to claim 6, characterized in that said oxygen-containing insulating film (40) is a silicon oxide film.

8. An apparatus according to claim 7, characterized in that said silicon oxide film (40) is a plasma silicon oxide film formed by a plasma method.

9. An apparatus according to claim 1, characterized in that said first insulating film (34, 40, 46) is a film (46) having a lamination of a silicon oxide film and a PSG film.

10. An apparatus according to claim 1, characterized in that said metal inter connection layer (32A, 32B) is a final metal inter connection layer closest to a surface layer of said apparatus.

F I G. 1

F I G. 2A

26 24

28
12
12

14A    18    20    14B

10

F I G.  2B

26 24

32A
32B
28
22
12
12

30A    18    20    30B

14A    14B

10

F I G.  2C

F I G. 2D

F I G. 2E

F I G. 3

F I G. 4

|  | PERCENTAGE OF DEFECTIVE UNITS |
|---|---|
| S−1 | 50〜90 % |
| S−2 | 1 %. |
| S−3 | 0 % |

# F I G. 5

$\triangle : Si/N \fallingdotseq 0.95$

$o : S /N \fallingdotseq 0.75$

$\Delta vth = vth\,(WRITE) - vth\,(INIT)$

INITIAL STATE

TIME [SEC]

# F I G. 6

F I G. 7

F I G. 8

F I G. 9